# DEMANDE DE BREVET EUROPEEN

(11) **EP 0 721 206 A1**
(43) Date de publication de la demande: **10.07.1996**
(21) Numéro de dépôt: 95402900.5
(22) Date de dépôt: 21.12.1995
(51) Int. Cl.: H01L 21/00, H05K 13/00

(54) **Dispositif de cambrage de pattes conductrices d'un support intermédiaire de circuit intégré**

(30) Priorité: 29.12.1994 FR 9415885
(71) Demandeur: BULL S.A., F-78430 Louveciennes (FR)
(72) Inventeur: Courant, Patrick, F-78220 Viroflay (FR)
(74) Mandataire: Denis, Hervé

(57) **Abrégé**

Il comprend une plaque de cambrage (14) comportant une empreinte (16) correspondant au cambrage à réaliser, des moyens de positionnement (8) du support intermédiaire par rapport à la plaque de cambrage (14), un organe de cambrage (22) disposé en regard de l'empreinte (16) pour agir sur une patte conductrice (4), et des moyens (24, 7) pour assurer un déplacement relatif de la plaque de cambrage et de l'outil de cambrage selon une première direction perpendiculaire à un plan contenant les pattes conductrices (4) et selon une seconde direction parallèle à une direction longitudinale des pattes conductrices (4).

## Description

La présente invention concerne un dispositif de cambrage de pattes conductrices d'un support intermédiaire de circuit intégré.

On sait que pour le montage de circuits intégrés en vue de leur incorporation à un circuit électronique, les circuits intégrés sont généralement montés sur un support intermédiaire formé d'un film isolant dans lequel une fenêtre a été découpée pour recevoir le circuit intégré et qui a été contrecollée avec une couche conductrice découpée pour former des pattes conductrices de liaison qui s'étendent en porte-à-faux à l'intérieur de la fenêtre recevant le circuit intégré. Les pattes conductrices sont généralement réalisées par attaque chimique de la couche conductrice qui a été contrecollée sur le film de sorte qu'après leur réalisation elles s'étendent dans le plan de la couche conductrice. La liaison des pattes conductrices avec le circuit intégré est effectuée par soudure par points des pattes conductrices sur les bornes du circuit intégré.

L'expérience a montré que si des pattes conductrices planes sont soudées aux bornes d'un circuit intégré il existe un risque de court-circuit sur le bord du circuit intégré, ce qui provoque la destruction de celui-ci. Pour éviter ce risque de court-circuit, on a donc réalisé des pattes conductrices qui sont cambrées afin de réaliser un contact ponctuel de la partie extrême des pattes conductrices avec les bornes du circuit intégré.

Les dispositifs connus à ce jour pour réaliser le cambrage des pattes conductrices comprennent une matrice ayant un rebord correspondant à une première ligne de pliure des pattes conductrices et un poinçon ayant une dimension inférieure à une dimension de la matrice pour réaliser une deuxième ligne de pliure des pattes conductrices lorsque le support intermédiaire est disposé sur la matrice et que le poinçon est engagé dans celle-ci. La matrice et le poinçon doivent donc avoir des dimensions exactement adaptées à la disposition des pattes conductrices sur le support intermédiaire et à la disposition des bornes sur le circuit intégré afin que l'extrémité des pattes conductrices coïncide avec les bornes du circuit intégré après l'opération de cambrage des pattes conductrices. Il n'est donc pas possible d'utiliser une même matrice et le poinçon associé en relation avec différents circuits intégrés ayant des bornes disposées selon des configurations différentes d'autant plus que les bornes sont généralement réparties sur les différents côtés du circuit intégré. Sachant que la matrice et le poinçon associé doivent être réalisés de façon extrêmement précise leur prix de revient est très élevé et n'est donc pas compatible avec leur utilisation en laboratoire où des prototypes de circuits électroniques sont généralement réalisés avec des circuits intégrés différents qui sont montés sur une carte en un très petit nombre d'exemplaires.

En outre, les dispositifs de cambrage existants ne permettent pas d'assurer un cambrage de pattes conductrices ayant des longueurs inégales ou des profils sinueux destinés à atteindre des bornes disposées à des distances variées du bord du circuit intégré.

Un but de l'invention est de proposer un dispositif de cambrage de pattes conductrices d'un support intermédiaire de circuit intégré permettant d'assurer un cambrage des pattes conductrices lorsque celles-ci sont disposées selon des configurations très variées.

En vue de la réalisation de ce but, on prévoit selon l'invention un dispositif de cambrage de pattes conductrices d'un support intermédiaire de circuit intégré comprenant une plaque de cambrage comportant un empreinte correspondant au cambrage à réaliser, des moyens de positionnement du support intermédiaire par rapport à la plaque de cambrage, un organe de cambrage disposé en regard de l'empreinte pour agir sur une patte conductrice, et des moyens pour assurer un déplacement relatif de la plaque de cambrage et de l'outil de cambrage selon une première direction perpendiculaire à un plan contenant les pattes conductrices et selon une direction parallèle à une direction longitudinale des pattes conductrices.

Ainsi on applique successivement chaque patte conductrice dans l'empreinte et dans le cas de pattes conductrices présentant des configurations très variées il est possible d'adapter la position de la plaque de cambrage par rapport à la patte conductrice à cambrer préalablement au cambrage de celle-ci et donc d'utiliser un dispositif unique pour le cambrage des pattes conductrices selon les diverses configurations.

Selon une version avantageuse de l'invention, le dispositif comporte des moyens pour assurer un déplacement relatif de l'outil de cambrage et de la plaque de cambrage selon une troisième direction perpendiculaire à un plan comprenant la première et la seconde directions. Ainsi on réalise successivement un cambrage de plusieurs pattes conductrices sans changer le positionnement du support intermédiaire par rapport à la plaque de cambrage.

Selon un autre aspect avantageux de l'invention, le dispositif de cambrage comporte une table mobile sur laquelle est fixé le support intermédiaire, et la plaque de cambrage est montée sur la table mobile pour se déplacer selon une direction parallèle à la direction longitudinale des pattes conductrices. Ainsi, sans changer la position du support intermédiaire on peut réaliser un cambrage des pattes conductrices en différents points de celles-ci.

Selon encore un autre aspect avantageux de l'invention, le dispositif comporte une plaque de calage disposée sous la plaque de cambrage, de préférence la plaque de calage est mobile par rapport à la plaque de cambrage selon une direction parallèle à la direction de déplacement de la plaque de cambrage et la plaque de calage a une extrémité biseautée en regard de la plaque de cambrage. Ainsi on contrôle de façon précise le positionnement de la plaque de cambrage par rapport aux pattes conductrices et on évite en particulier un risque de détérioration des pattes conductrices lors des déplacements de la patte de cambrage.

D'autres caractéristiques et avantages de l'invention apparaîtront encore à la lecture de la description qui suit d'un mode de réalisation particulier non limitatif de l'invention en relation avec les figures ci-jointes parmi lesquelles :
- la figure 1 est une vue en perspective partiellement écorchée du dispositif selon l'invention,
- la figure 2 est une vue en coupe partielle agrandie selon la ligne II-II de la figure 1,
- la figure 3 est une représentation schématique de l'outil de cambrage et de l'empreinte de la plaque de cambrage dans une première étape de fonctionnement du dispositif selon l'invention,
- la figure 4 est une vue analogue à celle de la figure 3 dans une seconde étape de fonctionnement du dispositif selon l'invention,
- la figure 5 est une vue analogue à celle de la figure 3 dans une troisième étape de fonctionnement du dispositif selon l'invention,
- la figure 6 est une vue analogue à celle de la figure 3 dans une quatrième étape de fonctionnement du dispositif selon l'invention.

On notera que pour une meilleure compréhension de l'invention les dimensions relatives des différentes pièces n'ont pas été respectées, le support intermédiaire et les pattes conductrices ayant en particulier été représentés selon une épaisseur proportionnellement beaucoup plus importante que leur épaisseur normale par rapport aux autres pièces constituant le dispositif selon l'invention.

En référence aux figures, le dispositif selon l'invention est destiné à être utilisé en relation avec un support intermédiaire de circuits intégrés comportant de façon connue en soi un film isolant 1 dans lequel a été réalisée une fenêtre 2 et sur lequel a été contrecollée une couche conductrice 3, par exemple une couche de cuivre dans laquelle des pattes conductrices 4 ont été réalisées, par exemple par attaque chimique. Les pattes conductrices 4 s'étendent en porte-à-faux vers l'intérieur de la fenêtre 2. Dans le mode de réalisation illustré le support intermédiaire ne comporte que trois pattes conductrices 4, une patte centrale courte et deux pattes latérales plus longues, bien que dans la réalité le nombre de pattes conductrices soit beaucoup plus élevé.

Le dispositif selon l'invention comporte une table mobile 5 s'étendant dans un plan horizontal et montée pour coulisser de façon connue en soi par rapport à un bâti non représenté selon deux directions, les mouvements de la table mobile étant respectivement commandés selon ces deux directions par des moteurs micrométriques 6 et 7. Sur sa face supérieure, la table mobile 5 comporte des pions de positionnement 8 sur lesquels sont engagés des perforations 9 du film 1 du support intermédiaire. Une plaque de maintien 10 est appliquée sur le support intermédiaire et est fixée à la table mobile 5 par des boulons moletés 11 vissés sur des tiges filetées 12 fixées à la table mobile 5. La plaque de maintien 10 comporte une fenêtre 13 permettant un accès aux pattes conductrices 4.

Une plaque de cambrage 14 est montée pour coulisser dans une rainure 15 de la table mobile 5 selon une direction parallèle à la direction longitudinale des pattes conductrices 4. A une extrémité, la plaque de cambrage comporte une empreinte 16 en forme de marche perpendiculaire à la direction longitudinale des pattes conductrices 4 dans le mode de réalisation illustré. A l'extrémité opposée la plaque de cambrage 14 comporte une barrette de manoeuvre 17 dont la position par rapport à la table mobile 5 est réglée par des vis micrométriques 18 fixées à la table mobile 5.

Le calage en hauteur de l'empreinte 16 est assuré par une plaque de calage 19 disposée dans une rainure 20 de la table mobile 5 et s'étendant en-dessous de la plaque de cambrage 14. A son extrémité en regard de la plaque de cambrage 14, la plaque de calage 19 comporte une partie biseautée 21 tournée vers la plaque de cambrage 14.

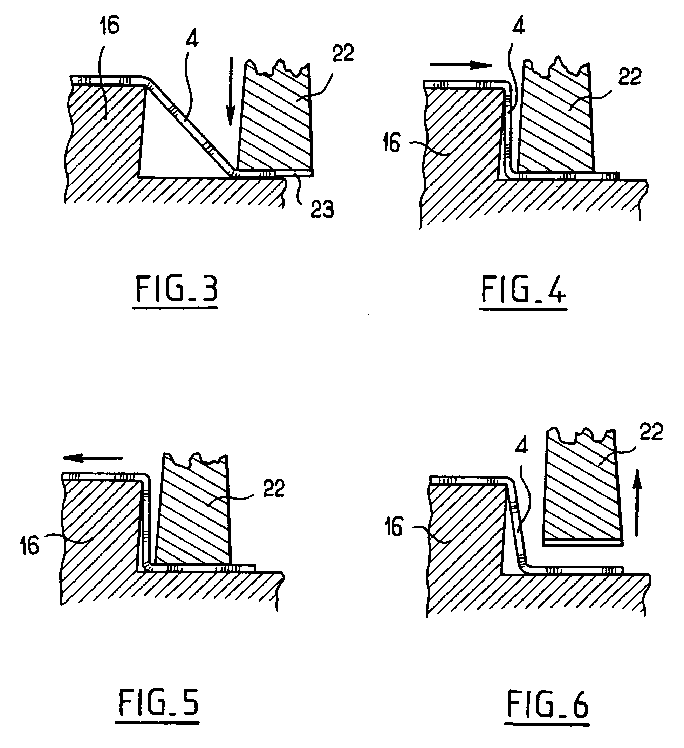

Un outil de cambrage 22 est disposé au-dessus de la table mobile 5 à l'aplomb de la fenêtre 13 de la plaque de maintien 10. L'outil de cambrage 22 comporte sur sa face inférieure tournée vers les pattes conductrices 4, une rainure 23 ayant une largeur légèrement supérieure à la largeur des pattes conductrices 4 et une hauteur légèrement inférieure à l'épaisseur des pattes conductrices 4 (voir figure 3). En section selon un plan parallèle à la direction longitudinale des pattes conductrices 4, l'outil de cambrage 22 a, comme illustré sur les figures 3 à 6, une forme légèrement trapézoïdale et l'empreinte 16 comporte une face sensiblement parallèle à la face en regard de l'outil de cambrage 22. L'outil de cambrage 22 est relié à un mécanisme d'actionnement 24 assurant un déplacement vertical de celui-ci.

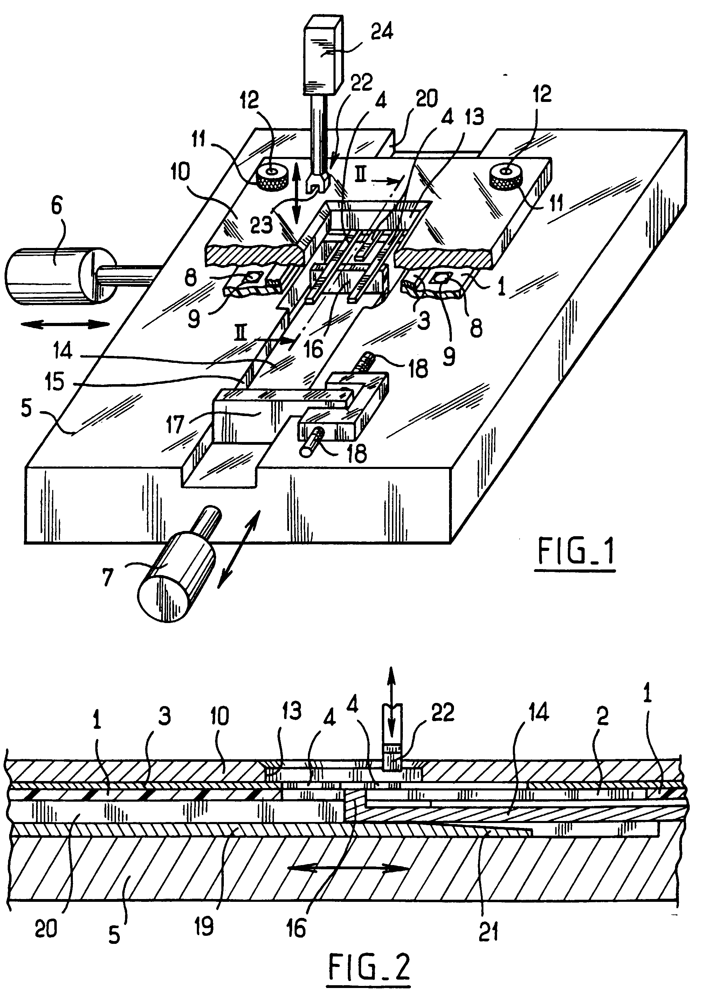

Le fonctionnement du dispositif selon l'invention est le suivant : un support intermédiaire comportant les pattes conductrices 4 est mis en place sur la table mobile 5 et est maintenu par la plaque de maintien 10, les pattes conductrices 4 étant disposées pour être accessibles par la fenêtre 13 de la plaque de maintien 10. La plaque de cambrage 14 est déverrouillée en faisant coulisser la plaque de calage 19 jusqu'à ce que la partie biseautée 21 soit à l'aplomb de l'empreinte 16 de sorte que la face supérieure de l'empreinte 16 vient à un niveau légèrement inférieur à la face inférieure des pattes conductrices 4. La plaque de cambrage 14 est alors déplacée au moyen des vis micrométriques 18 pour positionner l'empreinte 16 à l'aplomb des pattes conductrices 4 les plus longues, à une distance souhaitée de l'extrémité des pattes conductrices 4 pour la réalisation d'un cambrage de celles-ci. La plaque de calage 19 est alors ramenée sous la plaque de cambrage 14 pour assurer un positionnement en hauteur de celle-ci. La plaque de calage 19 est de préférence verrouillée dans cette position par des vis de blocage non représentées. La table mobile 5 est ensuite déplacée pour que l'outil de cambrage 22 soit à l'aplomb de l'une des pattes conductrices à cambrer, en étant légèrement décalé de l'empreinte 16 comme illustré sur la figure 2. L'outil de cambrage 22 est alors abaissé et effectue une première déformation de la patte conductrice 4 selon une première direction perpendiculaire à un plan contenant les plaques conductrices 4 comme illustré par la figure 3. Le moteur micrométrique 7 est actionné pour déplacer la table mobile 5 selon une direction parallèle à la direction longitudinale des pattes conductrices 4 et rapprocher ainsi l'empreinte 16 de l'outil de cambrage 22 comme illustré sur la figure 4. Cette étape permet de compenser l'élasticité du matériau et déforme la patte conductrice 4 selon la forme exacte de la patte de cambrage. Dans ce mouvement où l'extrémité de la patte conductrice 4 aurait tendance à se décaler par rapport à la direction longitudinale de la patte conductrice 4, elle est retenue par les flancs de la rainure 23 de l'outil de cambrage 22 et reste donc parfaitement positionnée selon la direction souhaitée. Le moteur micrométrique 7 est ensuite manoeuvré en sens inverse pour écarter l'empreinte 16 de l'outil de cambrage 22 comme illustré sur la figure 5, puis l'outil de cambrage 22 est relevé, la patte conductrice 4 conservant une forme cambrée comme illustré sur la figure 6.

L'outil de cambrage 22 ayant été relevé, le moteur micrométrique 6 est actionné pour déplacer la table mobile 5 afin d'amener la seconde patte conductrice longue à l'aplomb de l'outil de cambrage 22 et l'opération de cambrage est renouvelée comme expliqué ci-dessus à propos des figures 3 à 6. La plaque de cambrage 14 est ensuite déverrouillée et déplacée pour amener l'empreinte 16 dans la position désirée pour réaliser le cambrage de la patte 4 centrale plus courte que les deux pattes latérales. On remarquera que dans ce mouvement le déplacement de l'empreinte 16 n'interfère pas avec les pattes conductrices déjà cambrées et le cambrage de la patte centrale peut donc être réalisé comme précédemment au moyen de l'outil de cambrage 22.

Bien entendu l'invention n'est pas limitée au mode de réalisation décrit et on peut y apporter des variantes de réalisation sans sortir du cadre de l'invention tel que défini par les revendications.

En particulier, on peut associer la plaque de cambrage 14 à un moteur micrométrique permettant d'automatiser non seulement les opérations de cambrage proprement dites mais également l'ensemble des déplacement du dispositif en fonction de la configuration géométrique préétablie des pattes conductrices d'un support intermédiaire donné.

Dans le cas d'un support intermédiaire comportant des pattes conductrices s'étendant à partir des quatre côtés de la fenêtre 2, on pourra également prévoir deux plaques de cambrage selon des directions perpendiculaires chaque plaque de cambrage étant associée à un organe de manoeuvre et ayant une empreinte permettant d'effectuer successivement le cambrage des pattes conductrices s'étendant sur deux côtés en regard de la fenêtre 2 du support intermédiaire. On remarquera également que le dispositif selon l'invention permet de réaliser un cambrage selon une ligne oblique en utilisant une empreinte et un outil de cambrage appropriés.

Le dispositif selon l'invention_{_}peut non seulement être utilisé en laboratoire en raison de sa très grande facilité d'adaptation à différents circuits intégrés et aux supports intermédiaires correspondants, mais également dans une ligne de production compte tenu de la très grande facilité d'automatisation de ce dispositif.

## Revendications

1. Dispositif de cambrage de pattes conductrices (4) d'un support intermédiaire de circuit intégré caractérisé en ce qu'il comporte une plaque de cambrage (14) comportant une empreinte (16) correspondant au cambrage à réaliser, des moyens de positionnement (8) du support intermédiaire par rapport à la plaque de cambrage (14), un organe de cambrage (22) disposé en regard de l'empreinte (16) pour agir sur une patte conductrice (4), et des moyens (24, 7) pour assurer un déplacement relatif de la plaque de cambrage et de l'outil de cambrage selon une première direction perpendiculaire à un plan contenant les pattes conductrices (4) et selon une seconde direction parallèle à une direction longitudinale des pattes conductrices (4)

2. Dispositif selon la revendication 1, caractérisé en ce qu'il comporte des moyens (6) pour assurer un déplacement relatif de l'outil de cambrage (22) et de la plaque de cambrage (14) selon une troisième direction perpendiculaire à un plan comprenant la première et la seconde direction.

3. Dispositif selon la revendication 1, caractérisé en ce qu'il comporte une table mobile (5) sur laquelle est fixé le support intermédiaire, et en ce que la plaque de cambrage (14) est montée sur la table mobile (5) pour se déplacer selon une direction parallèle à la direction longitudinale des pattes conductrices (4).

4. Dispositif selon la revendication 3, caractérisé en ce qu'il comporte une plaque de calage (19) disposée sous la plaque de cambrage (14).

5. Dispositif selon la revendication 4, caractérisé en ce que la plaque de calage (19) est mobile par rapport à la plaque de cambrage (14) selon une direction parallèle à la direction de déplacement de la plaque de cambrage.

6. Dispositif selon la revendication 5, caractérisé en ce que la plaque de calage a une extrémité biseautée (21) en regard de la plaque de cambrage (14).

7. Dispositif selon la revendication 1, caractérisé en ce que l'outil de cambrage comporte sur une face tournée vers les pattes conductrices (4) une rainure (23) ayant une largeur sensiblement égale à celle des pattes conductrices (4).

8. Dispositif selon la revendication 1, caractérisé en ce que l'outil de cambrage (22) a une section trapézoïdale et l'empreinte (16) comporte une face parallèle à une face en regard de l'outil de cambrage (22).
